(19) Europäisches Patentamt / European Patent Office / Office européen des brevets

(11) **EP 3 355 370 B1**

(12) **EUROPEAN PATENT SPECIFICATION**

(45) Date of publication and mention
of the grant of the patent:
**07.09.2022 Bulletin 2022/36**

(21) Application number: **16848586.0**

(22) Date of filing: **20.09.2016**

(51) International Patent Classification (IPC):
*H01L 33/64* (2010.01)      *H01S 5/024* (2006.01)
*B23K 1/00* (2006.01)       *B23K 20/00* (2006.01)
*B23K 35/30* (2006.01)      *C22C 5/02* (2006.01)
*H01L 23/12* (2006.01)      *H01L 23/13* (2006.01)
*H01L 23/36* (2006.01)      *H01L 23/40* (2006.01)
*B23K 101/42* (2006.01)     *B23K 103/10* (2006.01)
*B23K 103/12* (2006.01)     *B23K 103/18* (2006.01)

(52) Cooperative Patent Classification (CPC):
**B23K 35/3013; B23K 1/00; B23K 20/00;
B23K 35/30; C22C 5/02; H01L 23/12; H01L 23/13;
H01L 23/36; H01L 23/40; H01L 33/641;
H01L 33/647;** H01L 2224/8384; H01L 2933/0075

(86) International application number:
**PCT/JP2016/077686**

(87) International publication number:
**WO 2017/051798 (30.03.2017 Gazette 2017/13)**

(54) **LED MODULE SUBSTRATE, LED MODULE, LED MODULE SUBSTRATE WITH A COOLER, AND METHOD OF PRODUCING A LED MODULE SUBSTRATE**

LED MODUL SUBSTRAT, LED MODUL, LED MODUL SUBSTRAT MIT KÜHLER, UND HERSTELLUNGSVERFAHREN FÜR LED MODUL SUBSTRAT

SUBSTRAT POUR MODULE DEL, MODULE DEL, SUBSTRAT POUR MODULE DEL AVEC REFROIDISSEUR, ET PROCÉDÉ DE FABRICATION DE SUBSTRAT POUR MODULE DEL

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **25.09.2015 JP 2015187831**

(43) Date of publication of application:
**01.08.2018 Bulletin 2018/31**

(73) Proprietor: **Mitsubishi Materials Corporation
Chiyoda-ku
Tokyo 100-8117 (JP)**

(72) Inventors:
• **NAGASE Toshiyuki
  Kitamoto-shi
  Saitama 364-0022 (JP)**
• **KOMASAKI Masahito
  Kitamoto-shi
  Saitama 364-0022 (JP)**
• **IWAZAKI Wataru
  Kitamoto-shi
  Saitama 364-0022 (JP)**

(74) Representative: **Hoffmann Eitle
Patent- und Rechtsanwälte PartmbB
Arabellastraße 30
81925 München (DE)**

(56) References cited:
EP-A1- 2 911 192      EP-A1- 3 269 491
WO-A1-2008/126564     WO-A1-2013/147144
WO-A1-2014/157112     JP-A- 2007 087 983
JP-A- 2008 277 654    JP-A- 2013 229 561
JP-A- 2014 026 769    JP-A- 2014 054 653
JP-A- 2014 112 696    JP-A- 2015 149 349

**Description**

TECHNICAL FIELD

The present invention relates to a light-emitting module substrate having excellent heat resisting properties, a light-emitting module, a light-emitting module substrate with a cooler, and a method of producing a light-emitting module substrate.

BACKGROUND ART

Light-emitting diode (LED) elements are widely used in various types of light sources by virtue of their long service life and stable light-emitting characteristics. The photo-transformation efficiency of such LED elements ranges from approximately 20% to 30%, and the remaining 70% to 80% of energy directly becomes heat in the LED elements. Meanwhile, LED elements are devices vulnerable to heat, and the guaranteed temperature for a general operation ranges from approximately -10°C to 85°C. Therefore, an LED module substrate for mounting an LED element is provided with a heat sink for efficiently diffusing heat generated in the LED element, a cooler for performing heat exchange, or the like. The same applies to not only LEDs but also to light-emitting elements.
In the related art, in LED modules, an insulating layer which is a substrate having insulating properties and a heat sink are bonded to each other using a Au-Sn alloy solder by virtue of high thermal conductivity, easiness of bonding, and the like. For example, in a case where AlN is used as an insulating layer and Cu having excellent thermal conductivity is used as a heat sink, a Cu thin-plate is formed on an AlN insulating layer, and the Cu thin-plate and the heat sink are bonded to each other using a Au-Sn alloy solder (for example, refer to Patent Documents 1 to 3).

CITATION LIST

PATENT LITERATURE

[Patent Document 1] Japanese Unexamined Patent Application, First Publication No. 2008-240007
[Patent Document 2] Japanese Unexamined Patent Application, First Publication No. 2015-070199
[Patent Document 3] Japanese Unexamined Patent Application, First Publication No. 2013-153157

Document WO 2014/157112 A1 discloses a power module, which is provided with an insulating substrate, a circuit layer that is formed on one surface side of the insulating substrate, and a metal layer that is formed on the other surface side of the insulating substrate. The circuit layer has a first aluminum layer that is formed of aluminum or an aluminum alloy and is bonded to the insulating substrate, and a first copper layer that is formed of copper or a copper alloy and is bonded to the first aluminum layer by solid-phase diffusion. The metal layer has a second aluminum layer that is formed of aluminum or an aluminum alloy. The thickness (t1) of the circuit layer and the thickness (t2) of the second aluminum layer of the metal layer satisfy the relation t1 < t2.
Document EP 2911192 A1 discloses a heat-sink-attached-power module substrate that has a configuration such that either one of a metal layer and a heat sink is composed of aluminum or an aluminum alloy, and the other one of them is composed of copper or a copper alloy, the metal layer and the heat sink are bonded together by solid phase diffusion bonding, an intermetallic compound layer formed of copper and aluminum is formed in a bonding interface between the metal layer and the heat sink, and an oxide is dispersed in an interface between the intermetallic compound layer and either one of the metal layer composed of copper or a copper alloy and heat sink composed of copper or a copper alloy in a layered form along the interface.

DISCLOSURE OF INVENTION

TECHNICAL PROBLEM

However, an insulating layer formed of ceramics or the like, and a heat sink formed of metal significantly differ from each other in thermal expansion coefficient. On the other hand, a Au-Sn alloy has high rigidity and poor malleability. Therefore, in a case where the insulating layer and the heat sink are bonded to each other using a Au-Sn alloy, the Au-Sn alloy cannot absorb the difference in heat expansion between the insulating layer and the heat sink caused due to heat generated in a light-emitting element. As a result, there is concern that a crack is generated in the Au-Sn alloy so that the insulating layer and the heat sink are delaminated from each other, or that a bonding part is damaged.

The present invention has been made in consideration of the foregoing circumstances, and an object thereof is to provide a light-emitting module substrate in which a bonding part of a material can be reliably prevented from being damaged due to heat generated by a light-emitting element, a light-emitting module, a light-emitting module substrate with a cooler, and a method of producing a light-emitting module substrate.

SOLUTION TO PROBLEM

In order to solve the problem described above, according to a first aspect of the present invention, there is provided a light-emitting module substrate according to claim 1.

According to the light-emitting module substrate of the first aspect of the present invention, it is possible to prevent damage to a bonding part between the insulating layer (for example, an insulating layer formed of ceramics) and the heat sink when a thermal cycle in which the light-emitting element is repetitively turned on and turned off is applied, by providing the insulating layer and the heat sink of which thermal expansion coefficients are significantly different from each other to be stacked via the metal layer and bonding the heat sink and the metal layer through solid-phase diffusion bonding.

That is, in a case where an insulating layer and a heat sink are bonded to each other using a bonding material having high rigidity, such as a Au-Sn alloy, as in the related art, there are cases where stress caused due to a difference between the thermal expansion coefficients cannot be absorbed, and the insulating layer and the heat sink are delaminated from each other. In contrast, according to the present invention, since the heat sink and the metal layer are bonded to each other through solid-phase diffusion bonding, the heat sink and the metal layer are firmly bonded to each other and the bonding part can be reliably prevented from being delaminated from each other.

In the light-emitting module substrate according to the first aspect of the present invention, the thickness of the metal layer is 0.4 mm to 2.5 mm.

Since a metal layer having such a thickness range is formed, thermal stress generated in the insulating layer can be effectively absorbed by the metal layer, and a crack or a fracture can be prevented from being caused in the insulating layer.

In the light-emitting module substrate according to the first aspect of the present invention, the heat sink is a multi-layer body comprising an AlSiC layer.

AlSiC is a material realized by causing a porous structure of SiC to be impregnated with aluminum or an aluminum alloy, and thermal conductivity and the thermal expansion rate of the material can be adjusted depending on the composition thereof. In addition to the impregnation method, AlSiC can also be produced through a powder sintering method and is characterized by high thermal conductivity, a low thermal expansion coefficient, and the like. Since a heat sink contains such AlSiC, it is possible to further improve heat dissipation characteristics of the heat sink and to reduce a difference in thermal expansion coefficient with respect to a cooler in contact with the heat sink.

In the light-emitting module substrate according to the first aspect of the present invention, an amount of warp within +25°C to +175°C on an element mounting surface in the circuit layer having the light-emitting element bonded thereto is 5 μm/10 mm or less.

Accordingly, even if a temperature cycle is applied repetitively by turning on and turning off the light-emitting element, it is possible to suppress deterioration of illuminance and fluctuation of an irradiation range caused due to a curve in the light-emitting element.

According to a second aspect of the present invention, there is provided a light-emitting module according to claim 4.

According to the light-emitting module of the second aspect of the present invention, it is possible to provide a light-emitting module in which the heat sink and the metal layer are bonded to each other through solid-phase diffusion bonding so that the heat sink and the metal layer are firmly bonded to each other and the bonding part can be reliably prevented from being delaminated from each other.

In the light-emitting module according to the second aspect of the present invention, the circuit layer is formed of aluminum or an aluminum alloy, and the circuit layer and the light-emitting element is bonded to each other via a Ag layer.

Since the circuit layer and the light-emitting element are bonded to each other using Ag having low electrical resistance, the circuit layer and the light-emitting element are reliably bonded to each other, and it is possible to reduce the electrical resistance between the circuit layer and the light-emitting element.

In the light-emitting module according to the second aspect of the present invention, the circuit layer is formed of copper or a copper alloy, and the circuit layer and the light-emitting element are bonded to each other via a Au-Sn alloy layer.

Since the circuit layer and the light-emitting element are bonded to each other using a Au-Sn alloy having low electrical resistance and high rigidity, the circuit layer and the light-emitting element are reliably bonded, and it is possible to reduce the electrical resistance between the circuit layer and the light-emitting element.

According to a third aspect of the present invention, there is provided a light-emitting module substrate with a cooler in accordance with claim 7.

According to the light-emitting module substrate with a cooler of the third aspect of the present invention, it is possible to provide a light-emitting module with a cooler in which the heat sink and the metal layer are bonded to each other through solid-phase diffusion bonding so that the heat sink and the metal layer are firmly bonded to each other and the bonding part can be reliably prevented from being delaminated from each other.

In the light-emitting module substrate with a cooler according to the third aspect of the present invention, a metal block, which is formed of a metal material different from a material of the cooler and increases a heat capacity of the cooler, is bonded to the cooler.

Since such a metal block is bonded to the cooler, the heat capacity of the cooler can be increased, heat propagated from the heat sink can be more efficiently absorbed, and the cooling ability of the cooler can be further enhanced.

In the light-emitting module substrate with a cooler according to the third aspect of the present invention, the cooler includes a recess portion into which the light-emitting module substrate is fitted. Since the recess portion is formed in the cooler, a side surface of the heat sink along a thickness direction also comes into contact with the cooler. Therefore, cooling characteristics for the heat sink by the cooler can be enhanced. In addition, since the light-emitting module substrate is accommodated in the recess portion, the light-emitting module substrate can be stably fixed to the cooler, and the strength of the light-emitting module substrate with a cooler can be enhanced.

According to a fourth aspect of the present invention, there is provided a method of producing a light-emitting module substrate according to claim 10.

According to the method of producing a light-emitting module substrate of the fourth aspect of the present invention, it is possible to prevent damage to a bonding part between the heat sink and the metal layer when a thermal cycle in which the light-emitting element is repetitively turned on and turned off is applied, by providing the insulating layer and the heat sink of which thermal expansion coefficients are significantly different from each other to be stacked via the metal layer and including the step of bonding the heat sink and the metal layer through solid-phase diffusion bonding. Accordingly, it is possible to reliably prevent the bonding part between the heat sink and the metal layer from being delaminated from each other.

ADVANTAGEOUS EFFECTS OF INVENTION

According to the present invention, it is possible to provide the light-emitting module substrate in which a bonding part of a material can be reliably prevented from being damaged due to heat generated by the light-emitting element, the light-emitting module, and the light-emitting module substrate with a cooler.

BRIEF DESCRIPTION OF DRAWINGS

FIG. 1 is a cross-sectional view showing an LED module of a first example not forming part of the present invention.
FIG. 2 is a cross-sectional view showing an LED module of a second example not forming part of the present invention.
FIG. 3 is a cross-sectional view showing an LED module of a third example not forming part of the present invention.
FIG. 4 is a plan view showing the LED module of the third example.
FIG. 5 is a cross-sectional view showing an LED module of a first embodiment of the present invention.
FIG. 6 is a cross-sectional view showing an LED module of a fourth example not forming part of the present invention.
FIG. 7 is a cross-sectional view showing an example of a method of producing an LED module substrate not forming part of the present invention.

BEST MODE FOR CARRYING OUT THE INVENTION

Hereinafter, with reference to the drawings, a LED module substrate, a LED module, and a LED module substrate with a cooler of the present invention will be described. The following embodiments are described in detail for better understanding of the gist of the invention, and the embodiments do not limit the present invention unless otherwise specified. In addition, in the drawings used in the description below, in order to make the features of the present invention easy to understand, there are cases where main parts are enlarged for convenience, and the dimensional ratio and the like of each of constituent elements are not necessarily the same as those of the actual configuration.

(First Example)

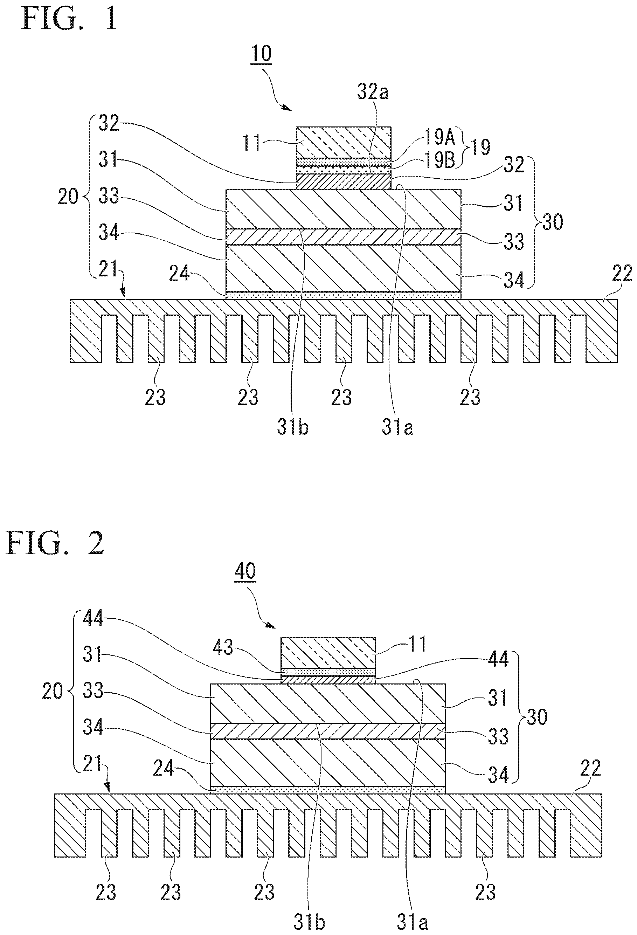

A LED module of a first example not forming part of the present invention will be described with reference to FIG. 1. In the first example, an LED element is used as a light-emitting element 11. In addition to the LED element, a laser diode element, a semiconductor laser element, or the like can be used as a light-emitting element.

FIG. 1 is a cross-sectional view showing the LED module of the first example.

An LED module 10 includes the LED element 11 and an LED module substrate with a cooler 20. The LED module substrate with a cooler 20 includes a cooler 21 and an LED module substrate 30.

The LED module substrate 30 has an insulating layer 31 which is a substrate having insulating properties, a circuit layer 32 which is laminated on one surface side 31a of the insulating layer 31, and a metal layer 33 and a heat sink 34 which are laminated in order on the other surface side 3 lb of the insulating layer 31.

For example, the insulating layer 31 is formed of ceramics, such as $Si_3N_4$ (silicon nitride), AlN (aluminum nitride), and $Al_2O_3$ (alumina), having excellent insulating properties and heat dissipation properties.

In the present example, the insulating layer 31 is formed of AlN. In addition, for example, the thickness of the insulating layer 31 is set within a range from 0.2 to 1.5 mm. In the present example, the thickness thereof is set to 0.635 mm.

The circuit layer 32 is a conductive plate electrically connected to the LED element 11. The circuit layer 32 is formed of aluminum, copper, silver, an alloy thereof, or the like having excellent conductivity. In the present embodiment, the circuit layer 32 is formed of an aluminum plate having a purity of 99.0 mass% or more. The circuit layer 32 is formed to have a thickness of 0.1 mm or less. If the thickness of the circuit layer 32 exceeds 0.1 mm, it is not possible to finely form a circuit pattern for mounting an LED element. Moreover, in a case where the thickness of the circuit layer 32 exceeds 0.1 mm, a stress buffering effect decreases unless the thickness of the metal layer 33 serving as a stress buffer layer (will be described below) is thickened to 0.6 mm or greater, for example, so that stress is increasingly applied to ceramics and a fracture is generated in the ceramics. The thickness of the circuit layer 32 preferably ranges from 0.01 mm to 0.09 mm, and more preferably ranges from 0.01 mm to 0.07 mm, but is not limited thereto.

An element mounting surface 32a in the circuit layer 32 having the LED element 11 bonded thereto is formed such that the amount of warp is 5 $\mu$m/10 mm or less (the amount of warp per length of 10 mm is 5 $\mu$m or less) within a temperature range from +25°C to +175°C. Since the amount of warp on the element mounting surface 32a of the circuit layer 32 is set to 5 $\mu$m/10 mm or less, the bonding strength between the circuit layer 32 and the LED element 11 is enhanced. Moreover, within the temperature range from +25°C to +175°C, curving stress applied to the LED element 11 is suppressed and damage to the LED element 11 is prevented. The amount of warp on the element mounting surface 32a within the range from +25°C to +175°C preferably ranges from 0 $\mu$m/10 mm to 3 $\mu$m/10 mm but is not limited thereto. In order to have the amount of warp on the element mounting surface 32a within the range described above, for example, bonding is performed using a tool for causing the element mounting surface 32a side to have a recessed shape at the time of bonding, and the amount of warp after being cooled to room temperature is controlled to be within the range.

The insulating layer 31 and the circuit layer 32 are directly bonded to each other using a brazing material. Examples of the brazing material include an Al-Cu-based brazing material and an Al-Si-based brazing material. In the present embodiment, an Al-Si-based brazing material is used. In the circuit layer 32, a predetermined circuit pattern can be formed through etching, for example, after a conductive metal plate is bonded to the insulating layer 31 using the brazing material.

The metal layer 33 is formed of aluminum or an aluminum alloy. In the present embodiment, a plate-shaped member formed of high purity aluminum having a purity of 99.98 mass% or more is used as the metal layer 33. For example, it is favorable to have the thickness of the metal layer 33 ranging from 0.4 mm to 2.5 mm. The metal layer 33 functions as the stress buffer layer by forming the metal layer 33 between the insulating layer 31 and the heat sink 34. That is, since the metal layer 33 is formed, it is possible to absorb the thermal stress caused due to a difference between the thermal expansion coefficients of the insulating layer 31 formed of ceramics and the heat sink 34 formed of metal and to prevent damage to the insulating layer 31. The thickness of the metal layer 33 preferably ranges from 0.6 mm to 2.0 mm, and more preferably ranges from 0.9 mm to 1.6 mm, but is not limited thereto.

In addition, if the metal layer 33 is formed of high purity aluminum having a purity of 99.98 mass% or more, deformation resistance is reduced. Therefore, when a thermal cycle in which the LED element 11 is repetitively turned on and turned off is applied, thermal stress generated in the insulating layer 31 can be effectively absorbed by the metal layer 33.

The insulating layer 31 and the metal layer 33 are directly bonded to each other using a brazing material. Examples of the brazing material include an Al-Cu-based brazing material and an Al-Si-based brazing material. In the present embodiment, an Al-Si-based brazing material is used.

As the heat sink 34, a material in which Cu is present on at least a bonding surface with respect to the metal layer 33 is used.

For example, it is possible to use pure copper, a copper alloy (Cu-Mo, Cu-Cr, or Cu-W), and a composite material containing copper (CuSiC). In addition to these materials in which Cu is present, the heat sink 34 may be a multi-layer body in which layers formed of aluminum, AlSiC, AlC, MgSiC, and the like are additionally bonded. In the present example, a Cu plate formed of oxygen-free copper is used as the heat sink 34.

The bonding surfaces of the metal layer 33 and the heat sink 34 are directly bonded to each other through solid-phase diffusion bonding. In the present example, solid-phase diffusion is performed on the bonding surfaces of the metal layer 33 and the heat sink 34 by performing surface treatment to each of the metal layer 33 formed of aluminum and the heat sink 34 formed of copper, heating the bonding surfaces at a temperature ranging from approximately 500°C to 548°C, and applying a pressure, thereby bonding the metal layer 33 and the heat sink 34 through solid-phase diffusion bonding of dissimilar metals. A metal compound layer of aluminum and copper is formed in the interface bonded through the method described, and the thickness of the layer may be 70 $\mu$m or less.

The LED module substrate with a cooler 20 is obtained by additionally bonding the cooler 21 to the LED module substrate 30 having the configuration described above.

The cooler 21 is configured to include a top plate portion 22 and a plurality of fins 23 formed in the top plate portion 22. The fins 23 are plate-shaped members disposed at predetermined intervals from each other. The cooler 21 is a so-called air cooling-type cooler in which air (refrigerant) circulates among the fins 23 so that the heat sink 34 bonded to the cooler 21 is cooled more efficiently.

For example, the cooler 21 may be a so-called water cooling-type cooler in which a plurality of flow channels for circulating cooling water are integrally formed with the top plate portion 22.

For example, the top plate portion 22 and the fins 23 configuring the cooler 21 are formed of aluminum or an aluminum alloy. Specifically, examples thereof include A3003, A1050, 4N-A1, and A6063. In the present embodiment, a rolled sheet of A1050 is used. The top plate portion 22 and the fins 23 may be configured to be formed as an integrated member, or the plurality of fins 23 may be configured to be bonded to the lower surface of the top plate portion 22 using a brazing material or the like. In a case where the top plate portion 22 and the plurality of fins 23 are configured to be different members, the top plate portion 22 and the plurality of fins 23 may be formed using raw materials different from each other. For example, the top plate portion 22 may be formed of A3003 and the plurality of fins 23 may be formed of A1050.

The heat sink 34 and the cooler 21 are in contact with each other via a thermal grease layer 24. In a case where thermal grease is used, the heat sink 34 and the cooler 21 are joined to each other through screwing, for example. In addition, the heat sink 34 and the cooler 21 can also be bonded to each other using a brazing material or the like. For example, the cooler 21 can be bonded to the heat sink 34 through brazing using an Al-Si-based brazing material and a flux containing F (fluorine), for example, a flux having $KAlF_4$ as a main component. The thermal grease is preferably grease realized by adding a filler such as zinc oxide, silica, or alumina to silicone oil.

The LED module 10 is obtained by installing the LED element 11 with respect to the LED module substrate with a cooler 20 having the configuration described above.

As the LED element 11, it is possible to use LED elements of various types of configurations in accordance with light-emitting wavelength bands or shapes.

The LED element 11 is bonded to (installed in) the element mounting surface 32a of the circuit layer 32 via a Ag layer 19. For example, the Ag layer 19 is formed of a sintered body of Ag powder. In the present embodiment, the Ag layer 19 includes two layers (Ag bonding layer 19A and Ag baked layer 19B). The Ag baked layer 19B is preferably realized by coating the surface of the circuit layer 32 with a paste formed of Ag powder and glass powder, and drying and baking the coated surface. In addition, the Ag bonding layer 19A may be sintered at a temperature of 300°C or lower. For example, the Ag bonding layer 19A is coated with pasted nano-Ag powder, is sintered, and is bonded.

According to the LED module 10 having the configuration described above, the LED module substrate with a cooler 20 and configuring the LED module 10, and the LED module substrate 30, damage to a bonding part between the insulating layer 31 formed of ceramics, and the heat sink 34 is prevented when a thermal cycle in which the LED element 11 is repetitively turned on and turned off is applied, by bonding the metal layer 33, which is disposed between the insulating layer 31 and the heat sink 34 having thermal expansion coefficients significantly different from each other, and the heat sink 34 through solid-phase diffusion bonding.

That is, in a case where an insulating layer and a heat sink are bonded to each other using a bonding material having high rigidity, such as a Au-Sn alloy, as in the related art, there are cases where stress caused due to a difference between the thermal expansion coefficients cannot be absorbed, and the insulating layer and the heat sink are delaminated from each other. In contrast, according to the present example, since the metal layer 33, which is disposed between the insulating layer 31 and the heat sink 34, and the heat sink 34 are bonded to each other through solid-phase diffusion bonding, the heat sink 34 and the metal layer 33 are firmly bonded to each other and the bonding part can be reliably prevented from being delaminated from each other.

In addition, since the metal layer 33 serving as a stress buffer layer is additionally provided between the insulating layer 31 and the heat sink 34, thermal stress generated in the insulating layer 31 can be effectively absorbed by the metal layer 33, and a crack or a fracture can be prevented from being caused in the insulating layer 31.

(Second Example)

A LED module of a second example not forming part of the present invention will be described with reference to FIG. 2.

FIG. 2 is a cross-sectional view showing the LED module of the second example. The same reference signs are applied to members having the same configuration as the LED module of the first example, and a detailed description of the structures and operations thereof will be omitted. In the second example, the LED element 11 is used as the light-emitting element 11.

An LED module 40 of the second example includes the LED element 11 and the LED module substrate with a cooler 20. The LED module substrate with a cooler 20 includes the cooler 21 and the LED module substrate 30.

The LED module substrate 30 has the insulating layer 31 which is a substrate having insulating properties, a circuit layer 44 which is laminated on the one surface side 31a of the insulating layer 31, and the metal layer 33 and the heat sink 34 which are laminated in order on the other surface side 3 lb of the insulating layer 31.

In the LED module 40 of the second example, the LED element 11 is bonded to (installed in) the circuit layer 44 constituted of a Cu plate via a Au-Sn alloy layer 43. That is, the circuit layer 44 of this embodiment is formed using a Cu plate having high adhesion with respect to the Au-Sn alloy layer 43.

The Au-Sn alloy layer 43 is formed by causing a Au-Sn alloy solder (for example, Au-20 mass% Sn) to melt at approximately 330°C. In addition, a copper plate having a thickness ranging from approximately 40 to 85 $\mu$m can be used as the circuit layer 44.

In such an LED module 40 as well, a bonding part between the insulating layer 31 formed of ceramics, and the heat sink 34 is prevented from being damaged when a thermal cycle in which the LED element 11 is repetitively turned on and turned off is applied, by bonding the metal layer 33, which is disposed between the insulating layer 31 and the heat sink 34 having thermal expansion coefficients significantly different from each other, and the heat sink 34 through solid-phase diffusion bonding.

In the LED module 40 of the second example, the LED element 11 is bonded to the circuit layer 44 using the Au-Sn alloy layer 43 having high rigidity. However, since the bonding part of the LED element 11 has a small area and the influence of thermal stress caused due to a difference in thermal expansion coefficient with respect to the circuit layer 44 side is small, the risk of damage to the Au-Sn alloy layer 43 due to the load of the thermal cycle is small.

(Third Example)

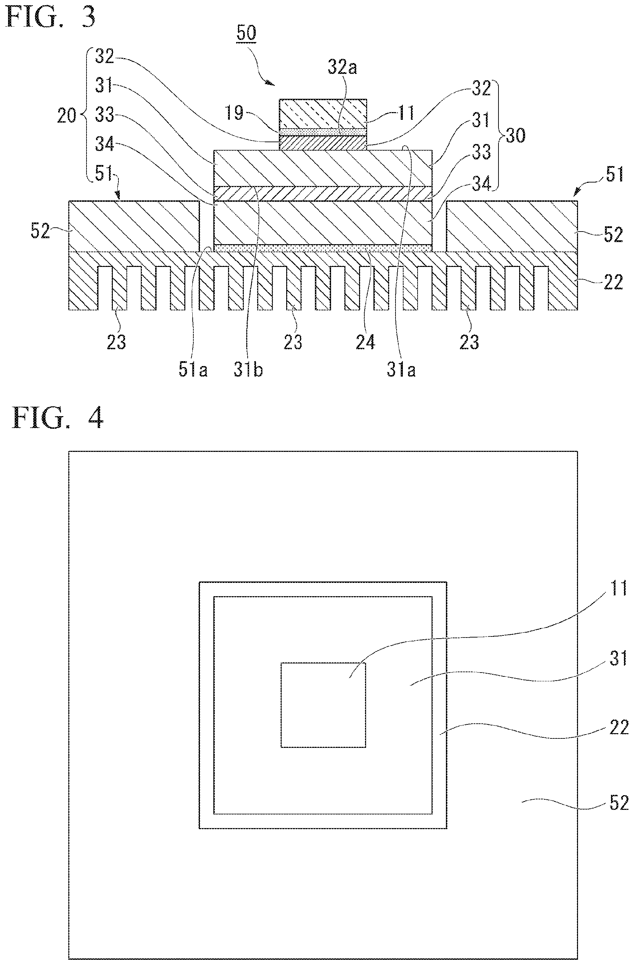

A LED module of a third example not forming part of the present invention will be described with reference to FIG. 3. In the third example, the LED element 11 is used as the light-emitting element 11.

FIG. 3 is a cross-sectional view showing the LED module of the third example. FIG. 4 is a plan view showing the LED module of the third example. The same reference signs are applied to members having the same configuration as the LED module of the first example, and a detailed description of the structures and operations thereof will be omitted.

An LED module 50 of the third embodiment includes the LED element 11 and the LED module substrate with a cooler 20. The LED module substrate with a cooler 20 includes a cooler 51 and the LED module substrate 30.

The LED module substrate 30 has the insulating layer 31 which is a substrate having insulating properties, the circuit layer 32 which is laminated on the one surface side 31a of the insulating layer 31, and the metal layer 33 and the heat sink 34 which are laminated in order on the other surface side 3 lb of the insulating layer 31.

In the LED module 50 of the third example, in a connection surface 51a of the cooler 51 which is in contact with the heat sink 34 via the thermal grease layer 24, a metal block 52 is bonded to a location outside the disposition region of the LED module substrate 30. The metal block 52 is formed of a metal material different from that of the cooler 51, for example, copper or a copper alloy. The heat capacity of the cooler 51 can be increased by bonding such a metal block 52 to the connection surface 51a of the cooler 51. Thus, it is possible to more efficiently absorb heat propagated from the heat sink 34 and to further enhance the cooling ability of the cooler 51.

The connection surface 51a of the cooler 51 and the metal block 52 are directly bonded to each other through solid-phase diffusion bonding. In the present example, solid-phase diffusion is performed on the bonding surfaces of the cooler 51 and the metal block 52 by performing surface treatment to each of the bonding surfaces of the cooler 51 formed of aluminum and the metal block 52 formed of copper, heating the bonding surfaces at a temperature ranging from approximately 500°C to 548°C, and applying a pressure, thereby bonding the cooler 51 and the metal block 52 through solid-phase diffusion bonding of dissimilar metals.

(First Embodiment)

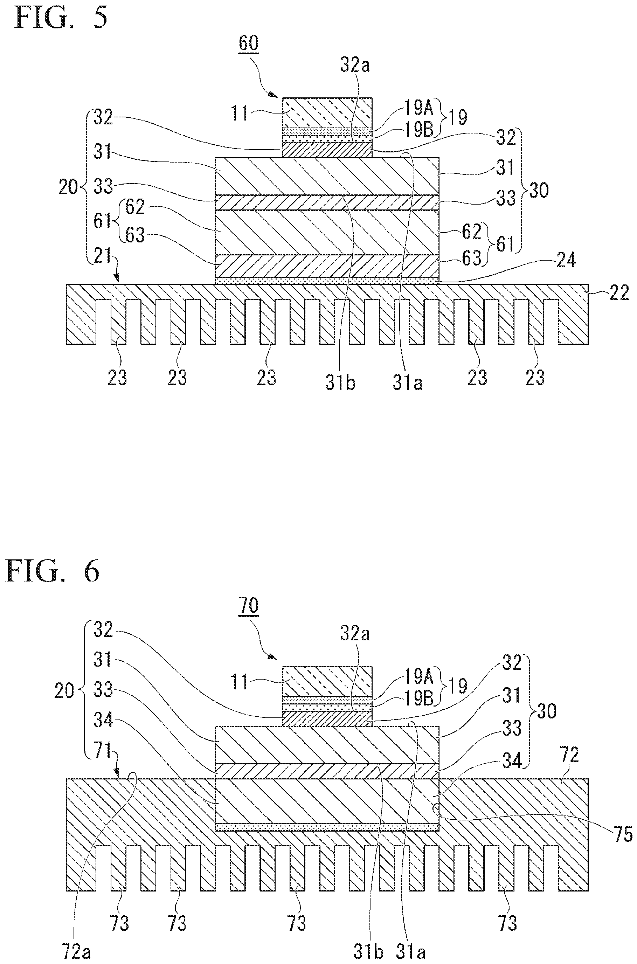

A LED module of a first embodiment of the present invention will be described with reference to FIG. 5. In the first embodiment, the LED element 11 is used as the light-emitting element 11.

FIG. 5 is a cross-sectional view showing the LED module of the first embodiment of the present invention. The same reference signs are applied to members having the same configuration as the LED module of the first example, and a detailed description of the structures and operations thereof will be omitted.

An LED module 60 of the first embodiment includes the LED element 11 and the LED module substrate with a cooler 20. The LED module substrate with a cooler 20 includes the cooler 21 and the LED module substrate 30.

The LED module substrate 30 has the insulating layer 31 which is a substrate having insulating properties, the circuit layer 32 which is laminated on the one surface side 31a of the insulating layer 31, and the metal layer 33 and a heat sink 61 which are laminated in order on the other surface side 3 lb of the insulating layer 31.

In the LED module 60 of the first embodiment, a multi-layer body including a copper layer 62 formed of copper or a copper alloy and an AlSiC layer 63 is used as the heat sink 61. In the present embodiment, the copper layer 62 is formed using oxygen-free copper. The AlSiC layer 63 is a material realized by causing a porous structure of SiC to be impregnated with aluminum or an aluminum alloy, and thermal conductivity and the thermal expansion rate of the material can be adjusted depending on the composition thereof. In addition to the impregnation method, AlSiC can also be produced through a powder sintering method and is characterized by high thermal conductivity, a low thermal expansion coefficient, and the like. In the present embodiment, AlSiC impregnated with aluminum (Al-Si-Mg-based alloy) of 30% is used. The impregnation ratio of aluminum to AlSiC preferably ranges from 20% to 70% but is not limited thereto.

Since the heat sink 61 is configured to include the AlSiC layer 63 containing AlSiC, and the copper layer 62, it is possible to improve heat dissipation characteristics of the heat sink 61 and to reduce the difference in thermal expansion coefficient with respect to the cooler 21 in contact with the heat sink 61.

(Fourth Example)

A LED module of a fourth example not forming part of the present invention will be described with reference to FIG. 6. In the fourth example, the LED element 11 is used as the light-emitting element 11.

FIG. 6 is a cross-sectional view showing the LED module of the fourth example. The same reference signs are applied to members having the same configuration as the LED module of the first example, and a detailed description of the structures and operations thereof will be omitted.

An LED module 70 of the fourth example includes the LED element 11 and the LED module substrate with a cooler 20. The LED module substrate with a cooler 20 includes a cooler 71 and the LED module substrate 30.

The LED module substrate 30 has the insulating layer 31 which is a substrate having insulating properties, the circuit layer 32 which is laminated on the one surface side 31a of the insulating layer 31, and the metal layer 33 and the heat sink 34 which are laminated in order on the other surface side 3 lb of the insulating layer 31.

In the LED module 70 of the fourth example, a recess portion 75 into which the LED module substrate 30 can be fitted is formed in the cooler 71. That is, the cooler 71 is configured to include a top plate portion 72 and a plurality of fins 73 formed in the top plate portion 72. The recess portion 75 is formed to be grooved from the one surface 72a of the top plate portion 72 toward the fins 73.

Such a recess portion 75 need only be formed to have a depth such that at least a part of the LED module substrate 30 can be accommodated therein. In the present example, the recess portion 75 is formed to have a depth such that a part near the bonding surfaces of the heat sink 34 and the metal layer 33 can be accommodated. In addition, in regard to the shape of the recess portion 75, its side surface is formed to have a shape being in contact with a side surface of the heat sink 34.

As in the present example, since the recess portion 75 is formed in the cooler 71, the side surface of the heat sink 34 along a thickness direction also comes into contact with the cooler 71. Therefore, cooling characteristics of the cooler 71 for the heat sink 34 can be enhanced. In addition, since the LED module substrate 30 is accommodated in the recess portion 75, the LED module substrate 30 can be stably fixed to the cooler 71, and the strength of the LED module substrate with a cooler 20 can be enhanced.

(Method of producing LED Module Substrate)

An example of a method of producing a LED module substrate not forming part of the present invention will be described.

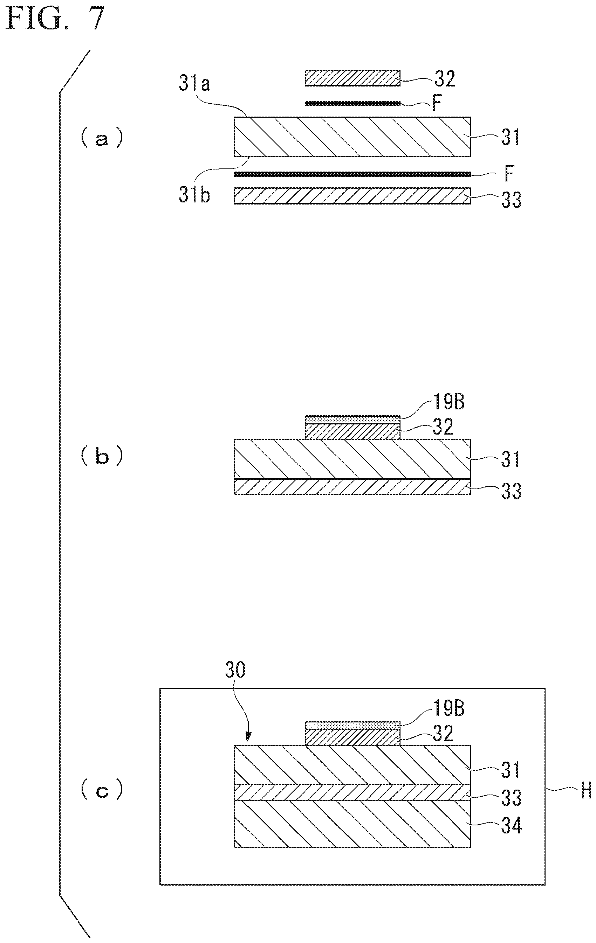

FIG. 7 is a cross-sectional view showing an example of the method of producing a light-emitting module substrate in stages. Here, a case where an LED element is used as a light-emitting element will be described.

When an LED module substrate of the present invention is produced, first, the circuit layer 32 is bonded to the one surface side 31a of the insulating layer 31, and the metal layer 33 is bonded to the other surface side 31b of the insulating layer 31, respectively (refer to FIG. 7(a)). For example, 4N-A1 having a thickness of approximately 0.1 mm can be used as the circuit layer 32. In addition, for example, 4N-A1 having a thickness of approximately 0.9 mm can be used as the metal layer 33.

In regard to bonding, a brazing material foil F is individually disposed between the insulating layer 31 and the circuit layer 32, and between the insulating layer 31 and the metal layer 33. The laminated matter is heated to a melting temperature of the brazing material foil F while being pressurized in a lamination direction. For example, an Al-Si-based brazing material can be used as the brazing material foil F. For example, a heating temperature at the time of bonding may be set to 640°C. Accordingly, the circuit layer 32 and the metal layer 33 are directly bonded to the insulating layer 31.

Next, the circuit layer 32 is coated with a glass-containing Ag paste and is baked at a temperature ranging from 567°C to 620°C, thereby forming a Ag sintered body constituted of the Ag baked layer 19B (refer to FIG. 7(b)). The glass-containing Ag paste contains Ag powder, glass powder, a resin, a solvent, and a dispersant. The paste has a content of the powder component constituted of Ag powder and glass powder set within a range from 60 mass% to 90 mass% of the glass-containing Ag paste in its entirety, and the remainder of the resin, the solvent, and the dispersant. A matter with a particle size ranging from 0.05 $\mu$m to 1.0 $\mu$m can be used as the Ag powder. For example, the glass powder contains any one, or two or more of lead oxide, zinc oxide, silicon oxide, boron oxide, phosphorus oxide, and bismuth oxide. A matter having a softening temperature of 600°C or less can be used. It is favorable to have the weight ratio A/G of a weight A of the Ag powder and a weight G of the glass powder within a range from 80/20 to 99/1.

Next, the heat sink 34 formed of copper or a copper alloy is stacked in the metal layer 33, and the metal layer 33 and the heat sink 34 are subjected to solid-phase diffusion bonding (step of solid-phase diffusion bonding: refer to FIG. 7(c)). In regard to solid-phase diffusion bonding, each of the bonding surfaces of the metal layer 33 and the heat sink 34 to be subjected to solid-phase diffusion bonding is smoothed in advance by eliminating a flaw and the like on the surface. Then, for example, the metal layer 33 and the heat sink 34 are disposed in a vacuum heating furnace H and are heated in a state of being pressurized in the lamination direction (pressure ranging from 5 to 35 kgf/cm$^2$ (0.49 to 3.43 MPa)). For example, as treatment conditions inside the vacuum heating furnace, the pressure is set within a range from 10$^{-6}$ Pa to 10$^{-3}$ Pa, the heating temperature is set within a range from 400°C to 548°C, and a retention time is set within a range from 0.25 hours to 3 hours. The metal layer 33 and the heat sink 34 are firmly bonded to each other through such solid-phase diffusion bonding. As preferable treatment conditions inside the vacuum heating furnace, the pressure is set within a range from 0.98 Pa to 1.96 Pa, the heating temperature is set within a range from 500°C to 535°C, and the retention time is set within a range from 0.5 hours to 2 hours, but the treatment conditions are not limited thereto.

The LED module substrate 30 shown in FIG. 1 can be obtained through the step described above.

When the LED element 11 is installed in the circuit layer 32 of the LED module substrate 30, for example, a Ag paste containing Ag particles with a particle size ranging from 50 nm to 350 nm is interposed between the LED element 11 and the Ag baked layer 19B and is baked at a temperature ranging from 200°C to 300°C, and then the LED element 11 can be installed on the circuit layer 32 (on the Ag baked layer 19B) via the Ag bonding layer 19A on the Ag baked layer 19B. In this case, the LED element 11 is bonded to the circuit layer 32 via the Ag layer 19. In addition, when the cooler 21 is attached to the LED module substrate 30, the cooler 21 and the heat sink 34 may be fixed by forming the thermal grease layer 24 between the top plate portion 22 of the cooler 21 and the heat sink 34.

Some embodiments of the present invention have been described. However, each of the embodiments is provided as an example and is not intended to limit the scope of the invention which is defined by the appended Claims.

EXAMPLES

Hereinafter, experimental examples in which the effects of the present invention have been verified will be described.

A circuit layer plate having the thickness disclosed in Table 1 was bonded to one surface of an AlN substrate (insulating layer) having a thickness of 1.0 mm, using a brazing material. In Examples 1 to 7 and Comparative Examples 1 and 2, a 4N-A1 plate was used as the circuit layer plate. An Al-Si-based brazing material foil was used as the brazing material and was caused to melt at 640°C. Then, the circuit layer plate and the AlN substrate were directly bonded to each other. In Examples 8 to 10 and Comparative Example 3, oxygen-free copper was used as the circuit layer plate. An active metal brazing material (Ag-Cu-Ti) was used as the brazing material and was caused to melt at 820°C. Then, the circuit layer plate and the AlN substrate were bonded to each other. A metal layer plate (4N-A1 plate) having the thickness disclosed in Table 1 was directly bonded to the other surface of the AlN substrate (insulating layer) using an Al-Si-based brazing material foil caused to melt at 640°C.

Thereafter, etching was performed to form an LED element circuit on a surface of the circuit layer plate bonded to the one surface of the AlN substrate, and a circuit layer was obtained.

Next, through the method disclosed in Table 1, a heat sink disclosed in Table 1 was bonded to a surface of the metal layer plate which has been bonded to the other surface of the AlN substrate. In a case where the method of bonding the heat sink was "solid-phase diffusion", the metal layer and the heat sink were bonded to each other by being heated at 520°C in a state where a load of 9 kg/cm$^2$ was applied in the lamination direction of the metal layer and the heat sink. In a case where the heat sink was AlSiC, solid-phase diffusion bonding was performed via a Cu foil. In a case where the method of bonding the heat sink was "Au-20 wt% Sn", the metal layer and the heat sink were bonded to each other by performing soldering between the metal layer and the heat sink at a bonding temperature of 330°C via a Au-20 wt% Sn solder having a thickness of 50 $\mu$m.

Then, an LED element was bonded to the circuit layer using the element bonding material disclosed in Table 1. In a case where the element bonding material disclosed in Table 1 was "Ag", a Ag baked layer was formed on the circuit layer through the method disclosed in the embodiment described above, and the circuit layer (Ag baked layer) and the LED element were bonded to each other using a Ag paste containing Ag particles. In a case where the element bonding material disclosed in Table 1 was "Au-20 wt% Sn", the circuit layer and the LED element were bonded to each other by performing soldering between the circuit layer, in which electroless Ni plating and Au plating were formed on the surface of the circuit layer, and the LED element at a bonding temperature of 330°C via a Au-20 wt% Sn solder having a thickness of 50 $\mu$m. Moreover, a cooler fin formed of Al (ADC12) was attached to the heat sink via thermal grease (G-747, manufactured by SHIN-ETSU Chemical Co., Ltd.). Consequently, the LED module substrates of Examples 1 to 10 and Comparative Examples 1 to 3 were obtained.

[Evaluation]

(Bonding Rate after Temperature Cycle)

A temperature cycle test was repetitively performed 2,000 for cycles on a temperature cycle of -40°C for 30 minutes and 175°C for 30 minutes, with respect to each of the LED modules in gas phase. A gas-phase temperature-cycle tester (TSD-100, manufactured by ESPEC Corp.) was used for the temperature cycle test. The bonding rates of the element bonding portion (element/circuit layer bonding portion) and the heat sink bonding portion (metal layer/heat sink bonding portion) after 2,000 cycles were evaluated by calculating a bonding area from the following expression indicating the bonding area, and using an ultrasonic-flaw detector (FineSAT 200, manufactured by HITACHI Power Solutions Co., Ltd.). In this case, the initial bonding area means the area ought to be bonded before bonding was performed, that is, the area of the element in a case where the element bonding portion was evaluated, and the area of the metal layer in a case where the heat sink bonding portion was evaluated. Since a delaminated portion was indicated in white in an image which was an ultrasonic-flaw detection image subjected to binarization processing, the white area was considered as the delaminated area.

$$\text{Bonding area } (\%) = \{(\text{initial bonding area}) - (\text{delaminated area})\}/(\text{initial bonding area}) \times 100$$

A case where the bonding area was less than 60% was evaluated as C, a case where the same ranged from 60% to less than 80% was evaluated as B, and a case where the same was 80% or more was evaluated as A.

The presence and absence of a fracture in ceramics after the temperature cycle was visually checked.

(Thermal Resistance)

When a voltage was applied to each of the LED modules, the element was caused to generate heat, heat dissipation fins were cooled by a fan, and a difference between the temperature of the element and the atmosphere temperature at that time was $\Delta$T, thermal resistance was calculated as follows: $\Delta$T (°C)/calorific value (W). The applied voltage was 12V, and the temperature of the element was 70°C. The temperature was measured in a steady state after five minutes using a thermo-viewer.

(Warp)

Each of the LED modules was consecutively measured within a range from +25°C to +175°C, and the amount of warp per length of 10 mm was measured using TherMoire (manufactured by Akrometrix, LLC). Among the amounts of warp measured at each temperature, the maximum amount of warp was evaluated as warp.

The evaluation result thereof is indicated in Table 1.

[Table 1]

| | Structure of package | | | | | | | | Evaluation result | | | | |
|---|---|---|---|---|---|---|---|---|---|---|---|---|---|
| | Element bonding material | Circuit layer material | Thickness (mm) | | | Method of bonding heat sink | Thickness of heat sink (mm) | | Bonding rate after temperature cycle | | Fracture in ceramics after temperature cycle | Thermal Resistance | Warp |
| | | | Circuit layer plate | AlN substrate | Metal layer plate | | Cu | AlSiC | Element bonding portion | Heat sink bonding portion | | (°C/W) | (μm/ 10 mm) |
| Example 1 | Ag | 4N-A1 | 0.1 | 1.0 | 0.9 | Solid-phase diffusion | 1.0 | - | A | A | None | 5.0 | 2.1 |
| Example 2 | Au-20 wt% Sn | 4N-A1 | 0.1 | 1.0 | 0.9 | Solid-phase diffusion | 1.0 | - | A | A | None | 5.7 | 2.2 |
| Example 3 | Ag | 4N-A1 | 0.1 | 1.0 | 0.6 | Solid-phase diffusion | 1.0 | - | A | A | None | 5.2 | 3.9 |
| Example 4 | Ag | 4N-A1 | 0.1 | 1.0 | 2.5 | Solid-phase diffusion | 1.0 | - | A | A | None | 5.5 | 3.7 |
| Example 5 | Ag | 4N-A1 | 0.1 | 1.0 | 0.4 | Solid-phase diffusion | 1.0 | - | A | B | None | 5.3 | 4.6 |
| Example 6 | Ag | 4N-A1 | 0.1 | 1.0 | 3.0 | Solid-phase diffusion | 1.0 | - | A | A | None | 5.9 | 4.3 |
| Example 7 | Ag | 4N-A1 | 0.1 | 1.0 | 0.9 | Solid-phase diffusion | - | 1.0 | A | A | None | 5.4 | 1.5 |
| Example 8 | Ag | Cu | 0.1 | 1.0 | 0.9 | Solid-phase diffusion | 1.0 | - | A | A | None | 4.9 | 2.0 |

EP 3 355 370 B1

| | Structure of package | | | | | | | | Evaluation result | | | | |
| --- | --- | --- | --- | --- | --- | --- | --- | --- | --- | --- | --- | --- | --- |
| | Element bonding material | Circuit layer material | Thickness (mm) | | | Method of bonding heat sink | Thickness of heat sink (mm) | | Bonding rate after temperature cycle | | Fracture in ceramics after temperature cycle | Thermal Resistance | Warp |
| | | | Circuit layer plate | AlN substrate | Metal layer plate | | Cu | AlSiC | Element bonding portion | Heat sink bonding portion | | (°C/W) | ($\mu$m/ 10 mm) |
| Example 9 | Au-20 wt% Sn | Cu | 0.1 | 1.0 | 0.9 | Solid-phase diffusion | 1.0 | - | A | A | None | 5.6 | 2.0 |
| Example 10 | Ag | Cu | 0.1 | 1.0 | 0.9 | Solid-phase diffusion | - | 1.0 | A | A | None | 5.2 | 1.6 |
| Comparative Example 1 | Au-20 wt% Sn | 4N-Al | 0.05 | 1.0 | 0.05 | Au-20 wt% Sn | 1.0 | - | A | C | None | 6.2 | 8.2 |
| Comparative Example 2 | Au-20 wt% Sn | 4N-A1 | 0.05 | 1.0 | 0.05 | Au-20 wt% Sn | - | 1.0 | A | A | None | 6.5 | 2.5 |
| Comparative Example 3 | Ag | Cu | 0.30 | 1.0 | 0.4 | Solid-phase diffusion | 1.0 | - | A | A | Present | 5.3 | 1.1 |

EP 3 355 370 B1

In the LED modules of Comparative Examples 1 and 2 in which the metal layer and the heat sink were bonded to each other using a Au-20 wt% Sn solder, thermal resistance was significant. Moreover, in Comparative Example 1, the amount of warp was 8.2 $\mu$m/10 mm, which was significant. In the LED module of Comparative Example 3 in which the thickness of the circuit layer plate exceeded the upper limit of the present invention, a fracture was generated in ceramics after the temperature cycle. On the other hand, in the LED modules of Examples 1 to 10, even after the temperature cycle was applied, no damage such as a crack was found in each of the bonding interfaces. In addition, it was checked that the thermal resistance was low. Moreover, it was checked that the amount of warp in the AlN substrate (insulating layer) could be suppressed within a range of 5 $\mu$m/10 mm or less.

INDUSTRIAL APPLICABILITY

According to a LED module substrate, a LED module, and a LED module substrate with a cooler of the present invention, it is possible to reliably prevent a bonding part of a material from being damaged due to heat generated by the light-emitting element.

REFERENCE SIGNS LIST

10    LED MODULE
11    LED ELEMENT
20    LED MODULE SUBSTRATE WITH COOLER
21    COOLER
30    LED MODULE SUBSTRATE
31    INSULATING LAYER
32    CIRCUIT LAYER
33    METAL LAYER
34    HEAT SINK

**Claims**

1.   A LED module substrate (30) comprising:

a circuit layer (32) for mounting a semiconductor light-emitting element (11) which is formed on one surface side (31a) of an insulating layer (31); and
a metal layer (33) formed of aluminum or an aluminum alloy and a heat sink (61) which are laminated in order on the other surface side (31b) of the insulating layer (31),
wherein the heat sink (61) is a multi-layer body comprising a copper layer (62) formed of copper or a copper alloy on the side of the metal layer (33), an AlSiC layer (63),

wherein the metal layer (33) and the heat sink (61) are directly bonded to each other by solid-phase diffusion bonding such that a metal compound layer of aluminum and copper is formed at the bonding interface of the metal layer (33) and the copper layer (62), and wherein a thickness of the circuit layer (32) is 0.1 mm or less.

2.   The LED module substrate (30) according to Claim 1, wherein a thickness of the metal layer (33) is 0.4 mm to 2.5 mm.

3.   The LED module substrate according to Claim 1 or 2, wherein the AlSiC layer (63) is porous structure of SiC impregnated with aluminum or an aluminum alloy.

4.   A LED module (10) comprising: a LED module substrate (30) according to Claim 1 or 2; and a semiconductor light-emitting element (11) which is bonded to the circuit layer (32) of the LED module substrate (30).

5.   The LED module (10) according to Claim 4, wherein the circuit layer (32) is formed of aluminum or an aluminum alloy, and the circuit layer (32) and the semiconductor light-emitting element (11) are bonded to each other via a Ag layer (19).

6.   The LED module (10) according to Claim 4, wherein the circuit layer (32) is formed of copper or a copper alloy, and the circuit layer (32) and the semiconductor light-emitting element (11) are bonded to each other via a Au-Sn alloy layer.

7. A LED module substrate with a cooler (20), comprising:

   a LED module substrate (30) according to Claim 1 or 2; and
   a cooler (21) being in contact with the heat sink (61) of the light-emitting module substrate (30), the cooler (21) being formed of aluminum or an aluminum alloy.

8. The LED module substrate with a cooler (20) according to Claim 7, further comprising a metal block (52) formed of copper or a copper alloy and bonded to the cooler (21).

9. The LED module substrate with a cooler (20) according to Claim 7, wherein the cooler (21) includes a recess portion (75) into which the LED module substrate (30) is fitted.

10. A method of producing a LED module substrate (30) comprising:

    forming a circuit layer (32) for mounting a semiconductor light-emitting element (11) on one surface side (31a) of an insulating layer (31);
    laminating a metal layer (33) formed of aluminum or an aluminum alloy and a heat sink (61) in order on the other surface side (31b) of the insulating layer (31); and
    performing solid-phase diffusion bonding directly between the heat sink (61) and the metal layer (33);
    wherein the heat sink (61) is a multi-layer body comprising a copper layer (62) formed of copper or a copper alloy on the side of the metal layer (33), and an AlSiC layer (63),

    wherein the AlSiC layer (63) is formed by impregnating a porous structure of SiC with aluminum or an aluminum alloy,
    wherein a metal compound layer of aluminium and copper is formed at the bonding interface, and
    wherein a thickness of the circuit layer (32) is 0.1 mm or less.

11. The method of producing a LED module substrate (30) according to Claim 10, wherein the solid-phase diffusion is performed by disposing the metal layer (33) and the heat sink (61) in a vacuum heating furnace and heating in a state of being pressurized in a lamination direction at a pressure of 0.49 to 3.43 MPa.

**Patentansprüche**

1. Substrat für LED-Modul (30), umfassend:

   eine Schaltungsschicht (32) zum Montieren eines lichtemittierenden Halbleiterelements (11), das auf einer Oberflächenseite (31a) einer Isolierschicht (31) gebildet ist; und
   eine Metallschicht (33), die aus Aluminium oder einer Aluminiumlegierung gebildet ist, und eine Wärmesenke (61), die in Reihenfolge auf der anderen Oberflächenseite (31b) der Isolierschicht (31) laminiert sind,
   wobei die Wärmesenke (61) ist ein Mehrschichtkörper ist, der aus Kupfer oder einer Kupferlegierung auf der Seite der Metallschicht (33) gebildet, eine AlSiC Schicht (63) umfasst (62),
   wobei die Metallschicht (33) und die Wärmesenke (61) direkt durch eine Festphasendiffusionsbindung aneinander gebunden sind, sodass eine Metallverbundschicht aus Aluminium und Kupfer an der Bindungsschnittstelle der Metallschicht (33) und der Kupferschicht (62) gebildet wird, und
   wobei die Dicke der Schaltungsschicht (32) 0,1 mm oder weniger beträgt

2. Substrat für LED-Modul (30) nach Anspruch 1,
   wobei eine Dicke der Metallschicht (33) 0,4 mm bis 2,5 mm beträgt.

3. Substrat für LED-Modul nach Anspruch 1 oder 2, wobei die AlSiC Schicht (63) eine poröse Struktur aus SiC ist, die mit Aluminium oder einer Aluminiumlegierung imprägniert ist.

4. LED-Modul (10), umfassend:

   ein Substrat eines LED-Moduls (30) nach Anspruch 1 oder 2; und

ein lichtemittierendes Halbleiterelement (11), das an die Schaltungsschicht (32) des Substrats des LED-Moduls (30) gebunden ist.

5. LED-Modul (10) nach Anspruch 4,
wobei die Schaltungsschicht (32) aus Aluminium oder einer Aluminiumlegierung gebildet ist, und die Schaltungsschicht (32) und das lichtemittierende Halbleiterelement (11) über eine Ag-Schicht (19) aneinander gebunden sind.

6. LED-Modul (10) nach Anspruch 4,
wobei die Schaltungsschicht (32) aus Kupfer oder einer Kupferlegierung gebildet ist, und die Schaltungsschicht (32) und das lichtemittierende Halbleiterelement (11) über eine Au-Sn Legierungsschicht aneinander gebunden sind.

7. Substrat eines LED-Moduls mit einem Kühler (20), umfassend:

ein Substrat eines LED-Moduls (30) nach Anspruch 1 oder 2; und
einen Kühler (21), der in Kontakt mit der Wärmesenke (61) des Substrats des lichtemittierenden Moduls (30) ist, wobei der Kühler (21) aus Aluminium oder einer Aluminiumlegierung gebildet ist.

8. Substrat eines LED-Moduls mit einem Kühler (20) nach Anspruch 7,
weiter einen Metallblock (52) umfassend, der aus Kupfer oder einer Kupferlegierung gebildet ist und an den Kühler (21) gebunden ist.

9. Substrat eines LED-Moduls mit einem Kühler (20) nach Anspruch 7,
wobei der Kühler (21) einen Aussparungsabschnitt (75) umfasst, in den das Substrat eines LED-Moduls (30) eingepasst ist.

10. Verfahren zur Herstellung eines Substrats eines LED-Moduls (30), umfassend:

Bilden einer Schaltungsschicht (32) zum Montieren eines lichtemittierenden Halbleiterelements (11) an einer Oberflächenseite (31a) einer Isolierschicht (31);
Laminieren einer Metallschicht (33), die aus Aluminium oder einer Aluminiumlegierung gebildet ist, und einer Wärmesenke (61) in Reihenfolge auf der anderen Oberflächenseite (31b) der Isolierschicht (31), und Ausführen einer Festphasendiffusionsbindung direkt zwischen der Wärmesenke (61) und der Metallschicht (33); wobei die Wärmesenke (61) ein Mehrschichtkörper ist, der eine Kupferschicht (62), die aus Kupfer oder einer Kupferlegierung auf der Seite der Metallschicht (33) gebildet ist, und eine AlSiC Schicht (63) umfasst,
wobei die AlSiC Schicht (63) durch Imprägnieren einer porösen Struktur aus SiC mit Aluminium oder einer Aluminiumlegierung gebildet ist,
wobei eine Metallverbundschicht aus Aluminium und Kupfer an der Bindungsschnittstelle gebildet wird, und
wobei eine Dicke der Schaltungsschicht (32) 0,1 mm oder weniger beträgt.

11. Verfahren zur Herstellung eines Substrats eines LED-Moduls (30) nach Anspruch 10,
wobei die Festphasendiffusion durch Anordnen der Metallschicht (33) und der Wärmesenke (61) in einem Vakuumerhitzungsofen und Erhitzen in einem Zustand unter Druck in einer Laminierungsrichtung mit einem Druck von 0,49 bis 3,43 MPa durchgeführt wird.

**Revendications**

1. Substrat de module à DEL (30) comprenant :

une couche de circuit (32) pour monter un élément électroluminescent à semi-conducteurs (11) qui est formée sur une face de surface (31a) d'une couche isolante (31) ; et
une couche métallique (33) formée d'aluminium ou d'un alliage d'aluminium et un dissipateur de chaleur (61) qui sont stratifiés dans l'ordre sur l'autre face de surface (31b) de la couche isolante (31),
dans lequel le dissipateur de chaleur (61) est un corps multicouche comprenant une couche de cuivre (62) formée de cuivre ou d'un alliage de cuivre sur le côté de la couche métallique (33), une couche d'AlSiC (63),
dans lequel la couche métallique (33) et le dissipateur de chaleur (61) sont directement liés l'un à l'autre par une liaison de diffusion en phase solide de telle sorte qu'une couche de composé métallique d'aluminium et de cuivre soit formée au niveau de l'interface de liaison de la couche métallique (33) et de la couche de cuivre (62) et

dans lequel l'épaisseur de la couche de circuit (32) est 0,1 mm ou moins.

2. Substrat de module à DEL (30) selon la revendication 1,
dans lequel une épaisseur de la couche métallique (33) est 0,4 mm à 2,5 mm.

3. Substrat de module à DEL selon la revendication 1 ou 2, dans lequel la couche d'AlSiC (63) est une structure poreuse de SiC imprégnée avec de l'aluminium ou un alliage d'aluminium.

4. Module à DEL (10) comprenant:

un substrat de module à DEL (30) selon la revendication 1 ou 2 ; et
un élément électroluminescent à semi-conducteurs (11) qui est lié à la couche de circuit (32) du substrat de module à DEL (30).

5. Module à DEL (10) selon la revendication 4,
dans lequel la couche de circuit (32) est formée d'aluminium ou d'un alliage d'aluminium et la couche de circuit (32) et l'élément électroluminescent à semi-conducteurs (11) sont liés l'un à l'autre par le biais d'une couche d'Ag (19).

6. Module à DEL (10) selon la revendication 4,
dans lequel la couche de circuit (32) est formée de cuivre ou d'un alliage de cuivre et la couche de circuit (32) et l'élément électroluminescent à semi-conducteurs (11) sont liés l'un à l'autre par le biais d'une couche d'Au-Sn.

7. Substrat de module à DEL ayant un refroidisseur (20) comprenant :

un substrat de module à DEL (30) selon la revendication 1 ou 2 : et
un refroidisseur (21) qui est en contact avec le dissipateur de chaleur (61) du substrat de module électroluminescent (30), le refroidisseur (21) étant formé d'aluminium ou d'un alliage d'aluminium.

8. Substrat de module à DEL ayant un refroidisseur (20) selon la revendication 7,
comprenant en outre un bloc métallique (52) formé de cuivre ou d'un alliage de cuivre et lié au refroidisseur (21).

9. Substrat de module à DEL ayant un refroidisseur (20) selon la revendication 7,
dans lequel le refroidisseur (21) inclut une partie en creux (75) dans laquelle le substrat de module à DEL (30) est fixé.

10. Procédé de production d'un substrat de module à DEL (30) comprenant :

la formation d'une couche de circuit (32) pour monter un élément électroluminescent à semi-conducteurs (11) sur une face de surface (31a) d'une couche isolante (31) ;
la stratification d'une couche métallique (33) formée d'aluminium ou d'un alliage d'aluminium et d'un dissipateur de chaleur (61) dans l'ordre sur l'autre face de surface (31b) de la couche isolante (31) et
la réalisation d'une liaison de diffusion en phase solide directement entre le dissipateur de chaleur (61) et la couche métallique (33) ;
dans lequel le dissipateur de chaleur (61) est un corps multicouche comprenant une couche de cuivre (62) formée de cuivre ou d'un alliage de cuivre sur le côté de la couche métallique (33), et une couche d'AlSiC (63),
dans lequel la couche d'AlSiC (63) est formée en imprégnant une structure poreuse de SiC avec de l'aluminium ou un alliage d'aluminium,
dans lequel une couche de composé métallique d'aluminium et de cuivre est formée au niveau de l'interface de liaison et
dans lequel une épaisseur de la couche de circuit (32) est 0,1 mm ou moins.

11. Procédé de production d'un substrat de module à DEL (30) selon la revendication 10,
dans lequel la diffusion en phase solide est réalisée en disposant la couche métallique (33) et le dissipateur de chaleur (61) dans un four de réchauffage à vide et en chauffant dans un état d'être sous pression dans une direction de stratification à une pression de 0,49 à 3,43 MPa.

FIG. 1

FIG. 2

FIG. 3

FIG. 4

FIG. 5

FIG. 6

# FIG. 7

(a)

31a

32

F

31

F

31b

33

(b)

19B

32

31

33

(c)

30

19B

32

31

33

34

H

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008240007 A
- JP 2015070199 A
- JP 2013153157 A
- WO 2014157112 A1
- EP 2911192 A1